(19) Europäisches Patentamt
European Patent Office
Office européen des brevets

(11) **EP 3 462 145 B1**

(12) **FASCICULE DE BREVET EUROPEEN**

(45) Date de publication et mention de la délivrance du brevet:
**17.03.2021 Bulletin 2021/11**

(51) Int Cl.:
***G01G 17/04*** *(2006.01)*

(21) Numéro de dépôt: **18197123.5**

(22) Date de dépôt: **27.09.2018**

(54) **RÉSONATEUR ÉLECTROMÉCANIQUE ET OPTIQUE**

ELEKTROMECHANISCHER UND OPTISCHER RESONATOR

OPTICAL AND ELECTROMECHANICAL RESONATOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **29.09.2017 FR 1759115**

(43) Date de publication de la demande:
**03.04.2019 Bulletin 2019/14**

(73) Titulaire: **Commissariat à l'Énergie Atomique et aux Énergies Alternatives
75015 Paris (FR)**

(72) Inventeurs:
• **VIROT, Leopold
38500 VOIRON (FR)**

• **AGACHE, Vincent
59152 CHÉRENG (FR)**
• **FEDELI, Jean-Marc
38120 SAINT-EGREVE (FR)**
• **HENTZ, Sébastien
38170 SEYSSINET PARISET (FR)**

(74) Mandataire: **INNOV-GROUP
310, avenue Berthelot
69372 Lyon Cedex 08 (FR)**

(56) Documents cités:
**WO-A1-2016/069634 US-A1- 2010 238 454**

**Description**

**DOMAINE TECHNIQUE**

Le domaine technique de l'invention est la détection d'analytes par des résonateurs électromécaniques, en particulier des microrésonateurs électromécaniques ou des nanorésonateurs électromécaniques.

**ART ANTERIEUR**

Les dispositifs électromécaniques de type MEMS (acronyme de Micro Electro Mechanical System) ou NEMS (acronyme de Nano Electro Mechanical System) sont d'usage courant dans de nombreux domaines industriels, où ils sont utilisés en tant qu'actionneurs ou en tant que détecteurs. Pour ne donner que quelques exemples, on trouve de tels dispositifs dans des accéléromètres, des capteurs de pression ou de mouvement, des téléphones portables et cette liste est loin d'être exhaustive. Les applications de ces dispositifs dans l'analyse pour la biologie ou la santé font également l'objet de nombreux développements.

Un grand nombre de dispositifs électromécaniques comportent une fine structure mobile, dite suspendue au-dessus d'un substrat, la structure suspendue étant apte à se déformer sous l'effet d'une contrainte, qu'il s'agisse d'une contrainte de pression, ou de l'application d'un champ électrique, par effet capacitif, ou de l'effet de la gravité ou encore de l'application d'une onde acoustique. De tels dispositifs associent un aspect mécanique, en l'occurrence un mouvement ou une déformation de la structure suspendue, ainsi que des moyens électriques pour induire et/ou détecter ce mouvement, d'où l'utilisation du terme "électromécanique". Un dispositif électromécanique peut être obtenu selon différents procédés de fabrication, au cours desquels différentes étapes de microfabrication s'enchaînent, permettant de délimiter une partie mobile dans un substrat et de former, sur ce même substrat, des électrodes en vis-à-vis permettant une transduction par couplage capacitif avec cette structure mobile. Certains procédés permettent de former un matériau piézoélectrique superposé ou adjacent à la structure mobile ; on peut alors actionner ou mesurer un déplacement de la structure mobile par transduction piézoélectrique. La partie mobile peut ensuite se déplacer ou se déformer relativement au substrat, en décrivant par exemple des ondulations ou des vibrations selon une fréquence de résonance.

Le brevet US8844340 décrit un résonateur électromécanique dont la partie mobile est traversée par un canal fluidique. Le canal fluidique est fonctionnalisé, de façon à retenir certaines particules, dites particules d'intérêt. Lors de la mise en œuvre du dispositif, un fluide circule dans le canal fluidique. Lorsque le fluide comporte des particules d'intérêt, ces dernières peuvent être retenues dans le canal fluidique fonctionnalisé. Il en résulte une augmentation de la masse du canal, ce qui se traduit par une variation de la fréquence de résonance. La mesure de la fréquence de résonance permet ainsi d'estimer une quantité de particules présentes dans le canal.

Le brevet US9182268 décrit un résonateur électromécanique comportant un circuit fluidique agencé pour comporter des sites de piégeages de particules en fonction de leur taille.

Comme exposé dans les brevets précités, la partie mobile du résonateur peut prendre différentes formes : il peut par exemple s'agir d'une poutre, usuellement désignée par le terme "cantilever", ou d'une plaque. La fréquence de résonance de la partie mobile peut être déterminée par différents moyens de détection. Il peut s'agir d'une détection capacitive, au moyen d'électrodes en liaison capacitive avec la partie mobile. Il peut également s'agir d'une détection piézorésistive, la déformation d'un matériau piézorésistif générant un signal de détection électrique dont la fréquence dépend de la fréquence de résonance. Il peut également s'agir d'une mesure optique, selon laquelle on mesure une déflexion d'un faisceau laser sous l'effet de la vibration du résonateur, une telle mesure étant décrite dans WO2016/069634. La détection capacitive ou la détection piézorésistive nécessitent la mesure de courants faibles, ce qui affecte leur rapport signal à bruit. Il en résulte une sensibilité limitée. La mise en œuvre d'une mesure optique, telle que précédemment décrite, nécessite un alignement précis d'un faisceau optique et n'est pas aisément intégrable dans des systèmes à usage industriel.

Le document US2010/238454 décrit un résonateur, dont la partie mobile comporte un réflecteur formé par un réseau de Bragg, et dont la partie fixe comporte un guide d'onde. Le guide d'onde est comporte également un réseau de Bragg. Les réseaux de Bragg respectifs du guide d'onde et de la partie mobile du résonateur définissent une cavité de type Fabry Perot, dont les propriétés optiques de transmission varient en fonction de la fréquence d'oscillation de la partie mobile. Un tel dispositif est cependant complexe à réaliser.

Les inventeurs ont conçu un résonateur électromécanique permettant d'obtenir une estimation précise de la fréquence de résonance, tout en étant aisément intégrable dans des résonateurs.

**EXPOSE DE L'INVENTION**

Un premier objet de l'invention est un résonateur électromécanique selon la revendication 1, comportant une partie fixe et un oscillateur, l'oscillateur étant apte à osciller selon une fréquence de résonance, l'oscillateur comportant:

▪ un canal fluidique, définissant un circuit fluidique, ménagé dans l'oscillateur, et destiné à accueillir un fluide, le canal fluidique étant apte à être déformé selon la fréquence de résonance, sous l'effet de l'oscillation de l'oscillateur ;

le résonateur étant caractérisé en ce qu'il comprend également :

▪ un guide d'onde, définissant un circuit photonique, ménagé dans l'oscillateur, et destiné à guider une onde lumineuse entre une entrée et une sortie du guide d'onde, le guide d'onde étant apte à être déformé selon la fréquence de résonance, sous l'effet de l'oscillation de l'oscillateur ;

▪ l'entrée du guide d'onde étant apte à être optiquement couplée à une source de lumière, la sortie du guide d'onde étant apte à être optiquement couplée à un photodétecteur, de façon que le photodétecteur soit apte à former un signal représentatif de l'onde lumineuse propagée par le guide d'onde vers le photodétecteur, cette dernière étant modulée selon une fréquence de modulation dépendant de la fréquence de résonance ;

de telle sorte que lorsque sous l'effet d'une variation d'une masse du fluide, induisant une variation de la fréquence de résonance, la variation de masse peut être détectée par une mesure de la fréquence de modulation ou par une mesure de la variation de la fréquence de modulation du signal formé par le photodétecteur.

De préférence, le canal fluidique et le guide d'onde s'étendent, dans l'oscillateur, en étant, au moins partiellement, symétriques l'un par rapport à l'autre. La symétrie peut notamment s'entendre par rapport à un point de l'oscillateur ou par rapport à un axe passant par l'oscillateur ou s'étendant selon l'oscillateur.

De préférence, l'oscillateur oscillant selon une amplitude, l'oscillateur comporte des ventres d'oscillation, au niveau desquels l'amplitude de l'oscillation est maximale, et des noeuds d'oscillation, au niveau desquels l'amplitude de l'oscillation est minimale, le canal fluidique et le guide d'onde s'étendant à travers au moins un ventre d'oscillation. Cela permet de maximiser la déformation du canal fluidique et du guide d'onde sous l'effet de l'oscillation.

Le guide d'onde peut notamment comporter :

- une couche, notamment une couche mince, d'un premier matériau, d'un premier indice de réfraction ;
- un canal plein, formé d'un deuxième matériau, d'un deuxième indice de réfraction, le deuxième indice de réfraction étant strictement inférieur au premier indice de réfraction, le canal plein étant ménagé, dans l'oscillateur, sous la couche mince, de telle sorte que l'onde lumineuse est apte à se propager dans la couche mince ménagée en regard au canal plein.

Le guide d'onde peut comporter un troisième matériau, d'un troisième indice de réfraction, le troisième indice de réfraction étant strictement inférieur au premier indice de réfraction. Le troisième matériau peut être un matériau ambiant, dans lequel est plongé l'oscillateur. Il peut également d'agir d'un matériau d'une couche d'encapsulation, ménagée sur la couche formée du premier matériau. Le troisième matériau peut être identique au deuxième matériau.

Ainsi, la couche, réalisée selon le premier matériau, forme un cœur du guide d'onde, permettant un confinement de l'onde lumineuse dans ladite couche.

De préférence, le canal fluidique définit un volume fluidique, et dans le canal plein définit un volume de confinement, le résonateur étant tel que le volume fluidique, multiplié par la densité du fluide apte à circuler dans le canal fluidique, est égal, à 30% près, au volume de confinement multiplié par la densité du deuxième matériau.

Le résonateur peut comporter au moins un élément d'ancrage, reliant l'oscillateur à la partie fixe. Le circuit fluidique et/ou le guide d'onde peuvent s'étendre le long de l'élément d'ancrage. De préférence, l'oscillateur s'étend, dans un plan principal, selon une largeur ou une longueur ou un diamètre, l'épaisseur de l'oscillateur, perpendiculairement au plan principal, étant au moins dix fois inférieure à ladite largeur, longueur ou diamètre.

Selon un mode de réalisation, l'oscillateur comporte une pluralité d'oscillateurs élémentaires, de telle sorte que le circuit fluidique est ménagé dans un premier oscillateur élémentaire et que le guide d'onde est ménagé dans un deuxième oscillateur élémentaire, différent du premier résonateur élémentaire, le premier oscillateur élémentaire et le deuxième oscillateur élémentaire étant reliés l'un à l'autre par un élément de liaison. L'élément de liaison s'étend de préférence entre deux ventres d'oscillation respectifs du premier oscillateur élémentaire et du deuxième oscillateur élémentaire. De préférence, le premier oscillateur élémentaire et le deuxième oscillateur élémentaire sont aptes à osciller selon une même fréquence de résonance. Le premier oscillateur élémentaire et le deuxième oscillateur élémentaire peuvent chacun s'étendre, dans un plan principal, selon une largeur ou une longueur ou un diamètre, l'épaisseur de chaque oscillateur élémentaire, perpendiculairement au plan principal, étant au moins dix fois inférieure à ladite largeur, longueur ou diamètre.

Le résonateur comporte de préférence au moins un transducteur d'actionnement, apte à induire une oscillation de l'oscillateur, le transducteur d'actionnement étant :

▪ une électrode, par exemple ménagée dans la partie fixe, apte à agir sur l'oscillateur par transduction électrostatique ;
▪ un élément piézoélectrique, relié à l'oscillateur.

De préférence, le transducteur d'actionnement s'étend entre la partie fixe du résonateur et l'oscillateur. Il peut en particulier être disposé au niveau d'un entrefer ménagé entre la partie fixe et le résonateur.

Selon un mode de réalisation, le guide d'onde peut comporter un guide d'onde de référence optiquement couplé à une cavité optique résonante, agencés de telle sorte que le photodétecteur est apte à détecter une onde lumineuse comportant une onde lumineuse de référence, se propageant à travers le guide d'onde de référence, et une partie d'une onde lumineuse dite confinée, se propageant dans la cavité optique résonante. Selon ce mode de réalisation, une partie de l'onde lumineuse guidée à travers le guide d'onde de référence peut, par couplage optique, se propager dans la cavité optique résonante. Une partie de l'onde lumineuse guidée dans la cavité optique résonante peut se découpler de la cavité optique et se propager dans le guide d'onde de référence.

Selon un mode de réalisation, le guide d'onde définit un chemin optique guidé sur l'oscillateur, et le résonateur comporte un guide d'onde de référence, s'étendant à l'extérieur de l'oscillateur, et définissant un chemin optique de référence. Le guide d'onde de référence est alors apte à être couplé à la source de lumière et au photodétecteur. Le guide d'onde de référence peut définir un trajet optique identique au trajet optique entre la source de lumière et le photodétecteur, le long du guide d'onde s'étendant sur l'oscillateur.

Un autre objet de l'invention est un procédé d'analyse d'un fluide selon la revendication 14, comportant des particules, à l'aide d'un résonateur, notamment selon le premier objet de l'invention, le procédé comportant les étapes suivantes :

a) introduction du fluide dans le canal fluidique;
b) actionnement de l'oscillateur, de façon à induire des oscillations de l'oscillateur selon une fréquence de résonance;
c) illumination du guide d'onde par une source de lumière, émettant une onde lumineuse, de telle sorte que le guide d'onde est apte à propager l'onde lumineuse émise par la source de lumière à travers l'oscillateur ;
d) détection, par un photodétecteur, d'une onde lumineuse transmise par le guide d'onde, et modulée par l'oscillation de l'oscillateur, et formation, par le photodétecteur, d'un signal représentatif de l'onde lumineuse détectée, le signal ainsi formé étant modulé selon une fréquence de modulation, la fréquence de modulation dépendant de la fréquence de résonance de l'oscillateur;
e) estimation d'une masse du fluide en fonction de la fréquence de modulation, ou d'une variation de la fréquence de modulation, du signal formé lors de l'étape d).

L'étape d) peut comporter une formation d'un signal d'interférence entre l'onde lumineuse transmise par le guide d'onde et une onde lumineuse de référence émise par la source de lumière et transmise par un guide d'onde de référence.

Le guide d'onde de référence peut s'étendre à l'extérieur de l'oscillateur ou sur l'oscillateur.

Le guide d'onde peut être configuré pour confiner l'onde lumineuse émise par la source de lumière, une partie de l'onde lumineuse, découplée du guide d'onde, se propageant vers le photodétecteur, l'intensité de l'onde lumineuse découplée du guide d'onde étant modulée selon une fréquence de modulation dépendant de la fonction de la fréquence de résonance de l'oscillateur.

D'autres avantages et caractéristiques ressortiront plus clairement de la description qui va suivre de modes particuliers de réalisation de l'invention, donnés à titre d'exemples non limitatifs, et représentés sur les figures listées ci-dessous.

## FIGURES

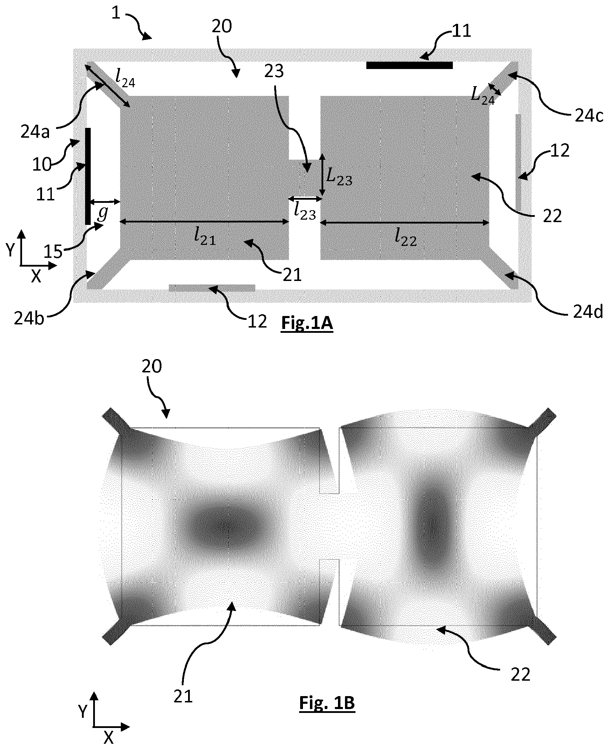

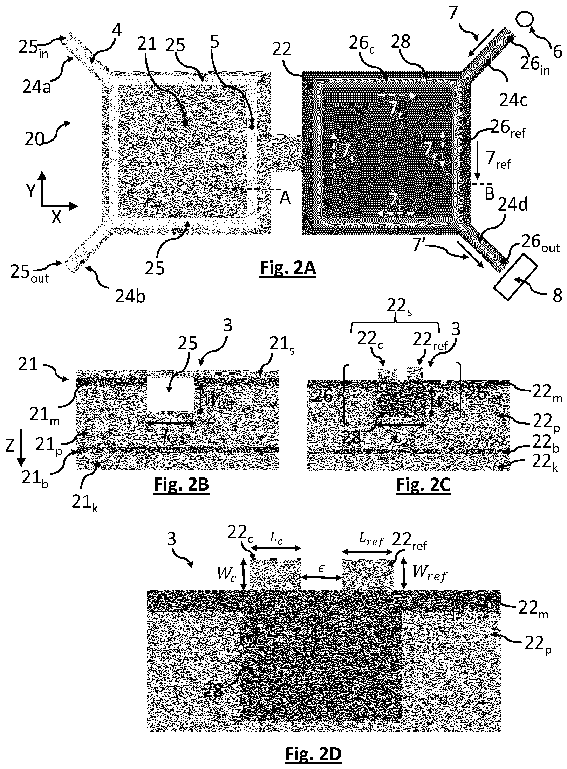

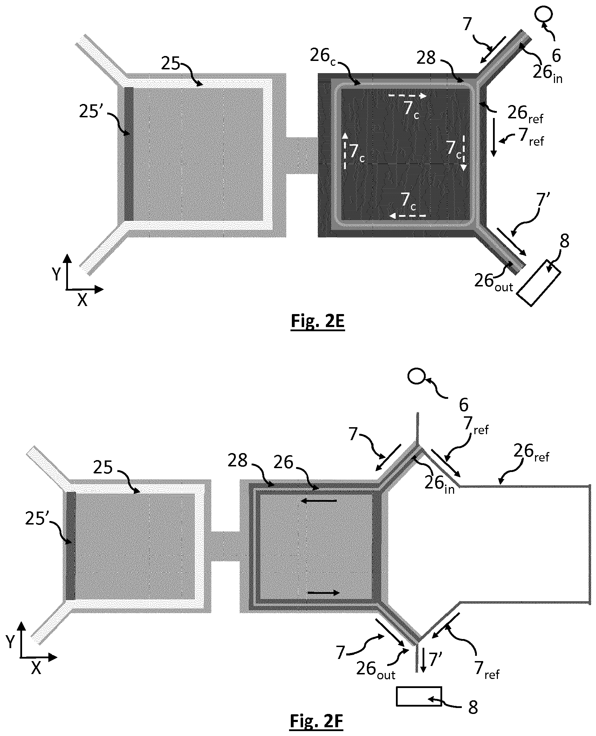

La figure 1A représente un exemple de résonateur selon l'invention. La figure 1B montre des nœuds et des ventres d'amplitude d'oscillation du résonateur. La figure 2A montre l'implantation d'un canal fluidique et d'un guide d'onde dans le résonateur décrit en lien avec la figure 1A. Les figures 2B et 2C sont des coupes respectivement de deux parties de la figure 2A. La figure 2D est un détail de la figure 2C. La figure 2E illustre une deuxième implantation d'un canal fluidique et d'un guide d'onde dans le résonateur décrit en lien avec la figure 1A. La figure 2F illustre une troisième implantation d'un canal fluidique et d'un guide d'onde dans le résonateur décrit en lien avec la figure 1A.

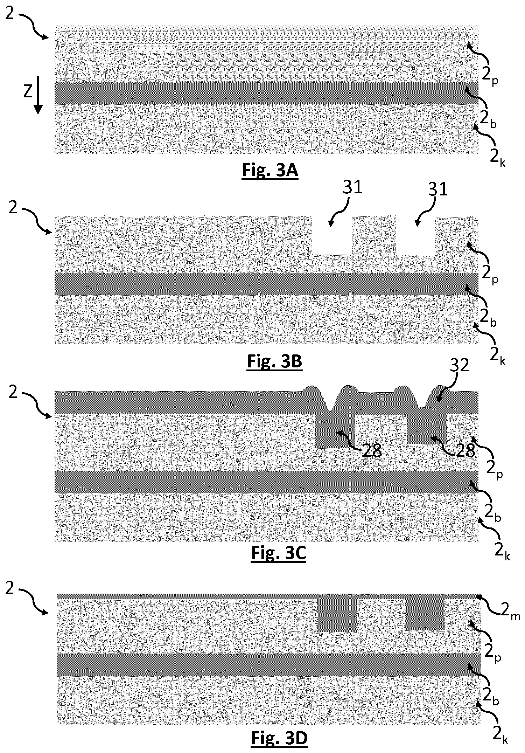

Les figures 3A à 3J montrent des étapes technologiques permettant la réalisation des résonateurs décrits sur les figures 2A à 2F.

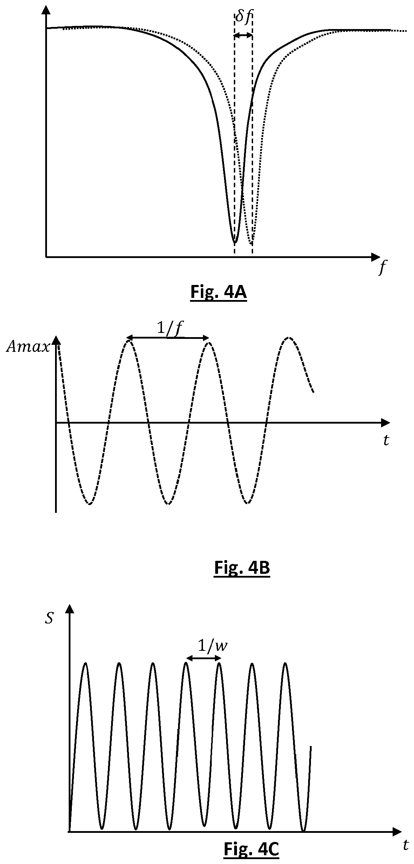

La figue 4A illustre une variation d'une fréquence de résonance d'un résonateur. La figure 4B schématise la déformation d'un oscillateur à une fréquence de résonance. La figure 4C montre l'évolution d'une intensité d'un signal formé par un photodétecteur, résultant de la déformation de l'oscillateur représentée sur la figure 4B.

Les figures 5A à 5F montrent différentes dispositions d'électrodes pour actionner le résonateur par effet capacitif.

Les figures 6A à 6C représentent différentes dispositions d'éléments d'ancrage entre l'oscillateur du résonateur et la partie fixe du résonateur.

Les figures 7A et 7B schématisent différentes géométries possibles de résonateurs. La figure 7C est une photographie d'un résonateur tel que représenté sur la figure 7B.

La figure 8 représente un autre mode de réalisation de l'invention.

## EXPOSE DE MODES DE REALISATION PARTICULIERS

La figure 1A représente un premier exemple de résonateur 1 selon l'invention. Le résonateur comporte une partie fixe 10 et une partie mobile 20, formant un oscillateur. La partie fixe 10 est séparée de la partie mobile 20 par un entrefer 15. La partie fixe est formée d'un substrat 2 de silicium, la partie mobile 20 et l'entrefer 15 résultant d'étapes de gravure du substrat. La figure 1A montre une vue du résonateur selon un plan principal XY. Le substrat utilisé est un substrat de silicium décrit ultérieurement, en lien avec les figures 3A à 3J. L'oscillateur, c'est-à-dire la partie mobile 20, est, dans cet exemple, formé de deux plaques carrées 21, 22 de longueur $l_{21}$, $l_{22}$ égales à 100 $\mu$m, et reliées par un élément de liaison 23, ce dernier prenant la forme d'une poutre. L'épaisseur de la partie fixe 10, selon une direction Z perpendiculaire au plan principal, est par exemple de quelques centaines de $\mu$m. La longueur $l_{23}$ de l'élément de liaison 23, selon l'axe X, est de l'ordre de 10 $\mu$m. La largeur $L_{23}$ de l'élément de liaison, selon l'axe Y, est de 33 $\mu$m. L'épaisseur de la partie mobile 20, c'est-à-dire de la première plaque 21, de la deuxième plaque 22 et de l'élément de liaison 23, selon la direction Z, est par exemple de 5 $\mu$m. Il est classique, pour des oscillateurs en forme de plaque, que le ratio largeur (ou longueur) sur épaisseur soit compris entre 5 et 50, par exemple de l'ordre de 20. La largeur $g$ de l'entrefer 15, s'étendant entre l'oscillateur 20 et la partie fixe 10 est de l'ordre de quelques centaines de nm à quelques $\mu$m, par exemple 500 nm.

La partie mobile 20 est reliée à la partie fixe 10 par des éléments d'ancrage 24a, 24b, 24c, 24d, prenant ici la forme de poutres de longueur $l_{24}$ comprise entre 20 et 25 $\mu$m, et de largeur $L_{24}$ d'environ 6 $\mu$m. Les éléments d'ancrage sont souples. Ils permettent de maintenir l'oscillateur 20 relié à la partie fixe 10, tout en autorisant une oscillation de l'oscillateur.

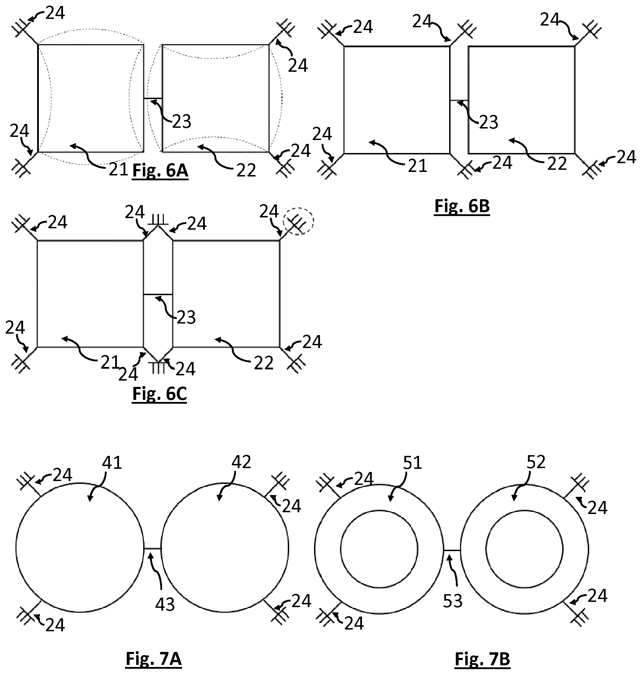

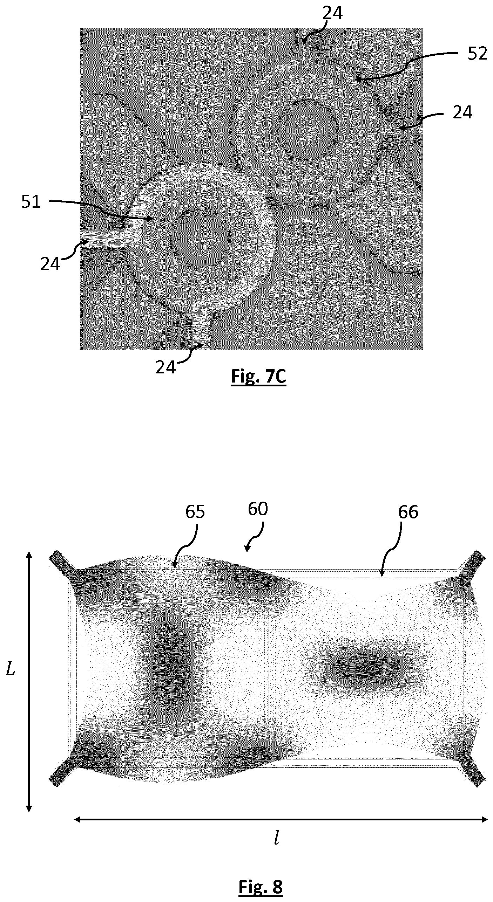

L'oscillateur peut avoir d'autres configurations géométriques. Il peut par exemple s'agir d'une poutre, ou d'un disque, d'un anneau, comme exposé sur les figures 7A à 7C, ou d'une plaque unique, comme représenté sur la figure 8. Quel que soit le mode de réalisation, l'oscillateur est apte à vibrer ou se déformer selon une fréquence de résonance f.

La partie fixe 10 comporte des électrodes 11, 12 s'étendant selon la direction Z, face au résonateur. On a représenté deux électrodes disposées face à la première plaque 21, tandis que deux autres électrodes sont disposées face à la deuxième plaque 22. Les électrodes 11 sont polarisées selon une composante continue $V_{DC}$ à laquelle s'ajoute une première composante alternative $V_{AC}$. Les électrodes 12 sont polarisées selon la composante continue $V_{DC}$, à laquelle s'ajoute une deuxième composante alternative $V'_{AC}$, la deuxième composante alternative $V'_{AC}$ étant déphasée de 180° par rapport à la première composante alternative $V_{AC}$. Dans certaines configurations, la composante continue peut être nulle. L'oscillateur est alors mis en mouvement selon les composantes alternatives $V_{AC}$ et $V'_{AC}$ dont la fréquence correspond à la moitié de la fréquence de résonance du résonateur. Les électrodes forment un moyen d'actionnement capacitif de la partie mobile 20. D'autres moyens d'actionnement sont envisageables, par exemple un actionnement piézoélectrique, selon lequel l'oscillateur est mis en vibration par un ou plusieurs transducteurs piézoélectriques disposés au contact de l'oscillateur.

Sous l'effet de l'actionnement électrostatique, une onde de flexion stationnaire se propage le long de chaque plaque 21 et 22 selon une fréquence de résonance f. La figure 1B représente la première plaque 21 et la deuxième plaque 22 en résonance selon le premier mode de Lamé. L'invention est applicable à des oscillateurs suivant d'autres modes de résonance, par exemple selon un mouvement de flexion ou de torsion. La figure 1B a été obtenue par simulation numérique, à l'aide du logiciel COMSOL. La fréquence de résonance f du premier mode de Lamé est donnée par l'expression suivante :

$$ f = \frac{1}{l\sqrt{2}} \sqrt{\frac{G}{\rho}} = 39.321 \text{ MHz} $$

où :

- $l$ est la longueur d'un côté d'une plaque ;
- $G$ est le module de cisaillement du matériau formant la plaque, en l'occurrence du silicium monocristallin ;
- $\rho$ est la masse volumique du matériau formant la plaque.

Dans cet exemple, les dimensions de la première plaque 21 et de la deuxième plaque 22 sont égales, et elles sont constituées d'un même matériau. Leur fréquence de résonance est identique. Les plaques 21 et 22 sont symétriques l'une par rapport à l'autre, selon un plan de symétrie P s'étendant perpendiculairement au plan principal XY, à égale distance de la première plaque et de la deuxième plaque.

D'une façon plus générale, lorsque l'oscillateur comporte différents oscillateurs élémentaires aptes à entrer en résonance, la fréquence de résonance de chaque oscillateur élémentaire est de préférence sensiblement identique, le terme sensiblement signifiant en admettant une tolérance de +/- 10 % ou +/- 20%. Le fait que la fréquence de résonance de chaque oscillateur soit identique limite la perte d'énergie par transfert de l'énergie mécanique entre les deux oscillateurs : le facteur de qualité du résonateur est donc optimal. Par facteur de qualité, on entend une grandeur connue de l'homme du métier, et représentant la finesse d'un pic de résonance. Ce pic de résonance apparaît sur un spectre fréquentiel, représentant l'amplitude du mouvement du résonateur qu'il s'agisse d'une ondulation ou d'une vibration, en fonction de la fréquence. Le facteur de qualité, à une fréquence de résonance, est déterminé à partir d'une largeur du pic de résonance apparaissant à ladite fréquence de résonance, par exemple sa largeur à mi-hauteur. Il peut notamment correspondre à un ratio entre ladite largeur à mi-hauteur et la fréquence de résonance.

Alternativement, le couplage entre les différents oscillateurs élémentaires définit une fréquence de résonance de l'oscillateur 20, cette fréquence de résonance étant différente des fréquences de résonances respectives de la plaque 21, formant un premier oscillateur élémentaire 21 et de la plaque 22, formant un deuxième oscillateur élémentaire 22. Une telle configuration est cependant moins favorable du point de vue du facteur de qualité, du fait de la dissipation d'énergie entre les deux oscillateurs élémentaires.

Dans cet exemple, on dispose de deux oscillateurs élémentaires, symétriques l'un par rapport à l'autre : la première plaque 21 et la deuxième plaque 22. Il est par ailleurs préférable que l'élément de liaison 23, reliant les deux plaques, soit disposé au niveau d'un ventre de vibration de chaque plaque, c'est-à-dire une position correspondant à une déformation d'amplitude maximale. Sur la figure 1B, les ventres de vibration sont repérés par des zones claires tandis que les nœuds de vibration, dont la déformation est minimale, sont repérés des zones sombres.

De préférence, l'élément de liaison 23 ne présente pas de mode de résonance à la fréquence de résonance $f$ de chaque plaque. Par ailleurs, les éléments d'ancrage 24a, 24b, 24c et 24d sont de préférence localisés au niveau des noeuds de vibration de chaque oscillateur élémentaire.

La figure 2A représente une vue de dessus, parallèlement au plan principal XY, d'un oscillateur 20 comportant les deux plaques 21 et 22 décrites en lien avec les figures 1A et 1B, formant deux oscillateurs élémentaires. La première plaque 21 comporte un canal fluidique 25, formant un circuit fluidique, dans lequel un fluide 4 à analyser, liquide ou gazeux, peut circuler. Le canal fluidique 25 est représenté en transparence sur la figure 2A. Dans cette configuration, les éléments d'ancrage 24a et 24b de la première plaque 21 comportent chacun le canal fluidique 25, permettant respectivement l'entrée du fluide 4 dans le circuit fluidique et sa sortie. De préférence, le canal fluidique 25 s'étend parallèlement au plan principal XY, dans l'épaisseur de la première plaque 21. La section du canal fluidique 25 peut être polygonale, par exemple rectangulaire, ou circulaire. Le diamètre, ou le plus grand côté, de la section de chaque canal peut être de l'ordre de ou inférieur à la moitié de l'épaisseur de chaque oscillateur élémentaire. Dans cet exemple la section du canal fluidique est carrée, de côté 4 $\mu$m. Le canal fluidique s'étend ainsi entre une entrée fluidique $25_{in}$, disposée au niveau de l'élément d'ancrage 24a, et une sortie fluidique $25_{out}$ disposée au niveau de l'élément d'ancrage 24b. Le canal fluidique peut comporter des moyens de piégeages d'une particule d'intérêt 5 à détecter, de tels moyens de piégeages, chimiques ou hydrodynamiques, étant décrits dans l'art antérieur.

La figure 2B schématise une coupe, selon l'axe Z, de la première plaque 21, la coupe étant réalisée selon un segment A représenté en pointillés sur la figure 2A. La première plaque 21, dont le procédé de formation est décrit en lien avec les figures 3A à 3J, est constituée d'une couche supérieure $21_s$, d'une couche intermédiaire $21_m$, d'une couche principale $21_p$, d'une couche enterrée $21_b$ et d'une couche support $21_k$. La couche supérieure $21_s$, la couche principale $21_p$ et la couche support $21_k$ sont en silicium. La couche intermédiaire $21_m$ et la couche enterrée $21_b$ sont en oxyde de silicium. Ces différentes couches sont décrites dans la suite du texte. Le canal fluidique 25 est ménagé dans la couche principale $21_p$ et dans la couche intermédiaire $21_m$ de la première partie 21 et est refermé par la couche supérieure $21_s$. Sur la figure 2A, la couche $21_s$ recouvrant le canal fluidique 25 a été supposée transparente, à l'aplomb du canal, de façon à faire apparaître le canal fluidique.

La figure 2C schématise une coupe de la deuxième plaque 22, selon l'axe Z, la coupe étant réalisée selon un segment B représenté en pointillés sur la figure 2A. La figure 2D est un détail de la figure 2C. La deuxième plaque, dont le procédé de formation est décrit en lien avec les figures 3A à 3J, est constituée d'une couche supérieure structurée $22_s$, d'une couche intermédiaire $22_m$, d'une couche principale $22_p$, d'une couche enterrée $22_b$ et d'une couche support $22_k$. A l'instar de la première partie, la couche supérieure $22_s$, la couche principale $22_p$ et la couche support $22_k$ sont en silicium. La couche intermédiaire $22_m$ et la couche enterrée $22_b$ sont en oxyde de silicium.

La deuxième plaque 22 comporte un guide d'onde 26, configuré pour former un guide de lumière entre une entrée $26_{in}$ et une sortie $26_{out}$. Elle comporte également un canal 28, dit canal plein, de géométrie similaire à celle du canal fluidique 25, ménagé dans la couche principale $22_p$. Le canal plein 28 est rempli d'un matériau, dit matériau de remplissage, dont la densité est comparable à celle du fluide 4 destiné à circuler dans le canal fluidique 25 de la première plaque 21. Dans l'exemple représenté sur les figures 2A, 2C et 2D, le guide d'onde 26 comporte un guide d'onde de référence $26_{ref}$ optiquement couplé à une cavité photonique résonante $26_c$. Comme on peut le voir sur la figure 2C, le guide d'onde de référence $26_{ref}$ est formé par une structuration de la couche supérieure $22_s$, de manière à obtenir une poutre $22_{ref}$ s'étendant sur le canal plein 28, formant un canal photonique de référence. La cavité photonique résonante $26_c$ est formée par une structuration de la couche supérieure $22_s$, de manière à obtenir un anneau parallèle au plan principal et s'étendant sur le canal plein 28. Sur la figure 2A, le sens de propagation de la lumière a été schématisé par des flèches : les flèches en tirets décrivent la propagation de la lumière $7_c$ confinée dans la cavité résonante $26_c$, tandis que les flèches en traits pleins matérialisent la propagation de la lumière $7_{ref}$ dans le guide de référence $26_{ref}$. Sur la figure 2A, la couche $22_m$ a été supposée transparente, de façon à faire apparaître le canal plein 28.

La lumière 7, émise par la source de lumière 6, pénètre dans le guide d'onde par une entrée photonique $26_{in}$, optiquement couplée à une source de lumière 6. Elle en ressort par une sortie photonique $26_{out}$, la sortie

étant optiquement couplée à un photodétecteur 8. Une partie de la lumière se propageant à travers le canal photonique de référence est couplée à la cavité photonique résonante $26_c$, et se propage en étant confinée dans cette dernière. Une partie de la lumière $7_c$ confinée dans la cavité photonique résonante $26_c$ se découple de la cavité résonante pour se propager dans le canal photonique de référence, vers la sortie photonique $26_{out}$. L'onde lumineuse 7', dite onde lumineuse de sortie, se propageant vers le photodétecteur 8, est comporte l'onde de référence $7_{ref}$ et une partie de l'onde lumineuse $7_c$ issue de la cavité résonante $26_c$.

A l'instar du canal fluidique 25, définissant un circuit fluidique, le guide d'onde 26 forme un circuit photonique, s'étendant en dessus du canal plein 28, et permettant la propagation d'une onde lumineuse entre l'entrée $26_{in}$ et la sortie $26_{out}$. La source de lumière peut être une source de lumière blanche ou une diode électroluminescente, de préférence couplée à un filtre optique passe-bande délimitant la bande spectrale d'émission autour d'une longueur d'onde λ pouvant être propagée par le guide d'onde 26. Il peut également s'agir d'une source laser. Le photodétecteur 8 peut par exemple être une photodiode.

Le guide d'onde 26 est formé par une gravure de la couche supérieure $22_s$, qui délimite un canal photonique de référence $22_{ref}$. La gravure de la couche supérieure permet également la formation d'un canal photonique $22_c$ fermé, en forme d'anneau, s'étendant en dessus du canal plein 28. Le canal photonique fermé $22_c$ constitue une cavité optique. L'effet guide d'onde est obtenu par une différence d'indice de réfraction entre chaque canal photonique, formé par la structuration de la couche supérieure $22_s$, d'indice de réfraction ni, et :

- d'une part, le matériau de remplissage du canal plein 28, d'indice $n_2$, le matériau de remplissage formant un deuxième matériau.
- d'autre part, le milieu extérieur 3 dans lequel est plongé le résonateur, par exemple de l'air ou une solution aqueuse, d'indice $n_3$. Le milieu extérieur forme alors un troisième matériau.

La couche supérieure $22_s$, après structuration, forme le cœur d'un guide d'onde lorsque ni> $n_2$ et $n_1$> $n_3$. Le guide d'onde 26 est alors constitué :

- du milieu extérieur 3 et du matériau de remplissage du canal 28, formant des éléments de confinement du guide d'onde ;
- de la couche supérieure $22_s$, structurée de façon à constituer un canal photonique de référence $22_{ref}$ ou le canal photonique de la cavité résonante $22_c$, chaque canal photonique formant le cœur du guide d'onde, apte à la propagation d'une onde lumineuse.

Dans les exemples représentés sur les figures 2C et 2E, les canaux photoniques $22_c$ et $22_{ref}$ sont formés par une couche supérieure $22_s$ de silicium monocristallin, d'épaisseur inférieure à 1 μm, cette dernière étant, dans cet exemple, égale à 220 nm. Cette épaisseur permet une propagation d'une onde lumineuse à la longueur d'onde de 1550 nm. Le matériau de remplissage comblant le canal plein 28 est de l'oxyde de silicium. Un tel canal peut être désigné par l'acronyme BOX, signifiant "Burried Oxyde". L'indice de réfraction de l'oxyde de silicium est de l'ordre de 1,45. L'effet guide d'onde est obtenu par la délimitation des canaux photoniques $22_c$ et $22_{ref}$ par des éléments de confinement dont l'indice de réfraction est significativement plus faible que l'indice de la couche supérieure, et dont l'épaisseur est suffisante. Le remplissage du canal plein 28 par un matériau de remplissage de type oxyde de silicium permet d'obtenir une couche suffisamment épaisse et d'indice de réfraction faible pour confiner la lumière dans le guide d'onde 26, et plus précisément dans le canal photonique de référence $22_{ref}$ et la cavité photonique $22_c$.

Dans cet exemple, le silicium monocristallin peut être utilisé pour constituer le cœur du guide d'onde 26, en particulier pour propager une onde lumineuse dans une plage de longueur d'onde comprise entre 1,1 μm et 1,6 μm. La propagation d'une onde lumineuse dans un tel matériau impose le recours à une couche mince, d'épaisseur submicronique, c'est-à-dire inférieure ou égale à 1 μm. Par exemple, la propagation du mode transverse électrique d'une onde lumineuse de longueur d'onde λ = 1550 nm dans une couche de silicium monocristallin suppose une épaisseur de couche mince de 220 nm. Ainsi, les épaisseurs respectives $W_{22c}$ et $W_{22ref}$ des canaux photoniques formant respectivement la cavité résonante $22_c$ et le cœur du guide d'onde de référence $22_{ref}$ sont de 220 nm. Leur largeurs respectives $L_{22c}$ et $L_{22ref}$ sont égales à 500 nm. L'espacement ε entre la cavité résonante $22_c$ et le canal photonique de référence $22_{ref}$ est par exemple compris entre 200 nm et 300 nm. D'une façon générale, le terme "couche mince" désigne une couche d'épaisseur inférieure à 5 μm, et de préférence inférieure à 1 μm ou 2 μm.

De préférence, le canal plein 28 décrit une géométrie analogue au canal fluidique 25 s'étendant dans la première plaque 21, de façon que les modes de résonance respectifs de la première plaque 21 et de la deuxième plaque 22 soient analogues. A l'instar de la première plaque 21, comportant un circuit fluidique, la deuxième plaque 22 comporte un circuit photonique, formé par le guide d'onde 26, dont le canal plein 28 forme un élément de confinement.

Il est préférable que la répartition spatiale des masses de chaque plaque soit similaire. Le canal fluidique 25 s'étend autour d'une première génératrice décrivant un premier motif dans le plan principal XY. Le canal plein 28 s'étend autour d'une deuxième génératrice décrivant un deuxième motif dans le plan principal XY. De préférence, le premier et le deuxième motifs sont, partiellement ou en totalité, symétriques l'un de l'autre, la symétrie étant entendue par rapport à un point ou par rapport à un axe ou par rapport à un plan, de préférence perpendiculaire au plan principal XY. Dans l'exemple de la figure 3A, les motifs respectivement décrits par la première génératrice et la deuxième génératrice sont symétriques par rapport au centre de l'élément de liaison 23, ainsi que par rapport au plan de symétrie P précédemment décrits. Afin d'obtenir une répartition des masses aussi proche que possible dans chaque plaque, cette condition de symétrie est assortie d'une condition quant à la masse de la première plaque 21 et de la deuxième plaque 22. Afin que les masses respectives des deux plaques soient aussi proches que possible, la masse du canal fluidique 25, rempli par le fluide 4, est de préférence sensiblement égale à la masse du canal plein 28. Cela se traduit par l'égalité suivante :

$$V_{25} \times \rho_{25} = V_{26} \times \rho_{26}, \ (2)$$

où

- $V_{25}$ et $V_{26}$ sont les volumes respectifs du canal fluidique 25 et du guide d'onde 26.
- $\rho_{25}$ et $\rho_{26}$ sont les densités respectives du fluide 4 à analyser et du guide d'onde 26.

Cela revient à écrire que :

$$l_{25} \times S_{25} \times \rho_{25} = l_{26} \times S_{26} \times \rho_{26}, \ (3)$$

où :

- $l_{25}$ et $l_{26}$ sont les longueurs respectives du canal fluidique 25 et du guide d'onde 26 ;
- $S_{25}$ et $S_{26}$ sont les sections respectives du canal fluidique 25 et du guide d'onde 26.

Dans les exemples représentés, le canal fluidique 25 est de section carrée, de telle sorte que $S_{25} = L_{25} \times W_{25} = L_{25}^2$, $L_{25}$ et $W_{25}$ étant respectivement la longueur et la largeur du canal fluidique, selon le plan principal XY.

Les égalités (2) et (3) peuvent être vérifiées à +/- 10 % ou +/- 20% près, une stricte égalité n'étant pas nécessaire. Dans l'exemple représenté sur les figures 2A à 2E, la structuration de la couche supérieure $22_s$ pour former le canal photonique de référence $22_{ref}$ ou la cavité résonante $22_c$ n'a qu'un effet marginal sur la répartition de la masse entre les deux parties 21 et 22 du résonateur.

Ainsi, lors du dimensionnement du canal fluidique 25, on prend en compte une densité $\rho_{25}$ d'un fluide 4 susceptible d'être analysé, et on dimensionne le canal fluidique en prenant en compte la densité.

Le canal fluidique 25 a une section relativement large, de façon à autoriser un écoulement du fluide 4 à analyser. Son diamètre (ou sa grande diagonale) est supérieur à 1 μm, et peut atteindre plusieurs μm. Dans la deuxième plaque 22, la géométrie du guide d'onde 26 est essentiellement définie par la géométrie du canal plein 28. Le canal plein 28, rempli d'oxyde de silicium a une épaisseur $W_{28} = 2$ μm selon la direction Z et une largeur $L_{28}$, dans le plan principal XY, de l'ordre de 4 ou 5 μm. La largeur et l'épaisseur du canal fluidique 25 sont par exemple égales à 4 μm. Compte tenu du fait que la géométrie du guide d'onde 26 dépend essentiellement du canal plein 28, les expressions (2) et (3) deviennent :

$$V_{25} \times \rho_{25} = V_{28} \times \rho_{28} \ (4),$$

$$l_{25} \times S_{25} \times \rho_{25} = l_{28} \times S_{28} \times \rho_{28}. \ (5).$$

Le canal plein 28 représente la quasi-totalité de la masse du guide d'onde 26, l'effet de la structuration de la couche supérieure $22_s$ pour former les canaux photoniques $22_{ref}$ ou $22_c$ pouvant être négligé.

Le motif, défini par le canal plein 28, est, dans le plan principal XY, de préférence symétrique d'au moins une partie du canal fluidique 25. Compte tenu de la densité de l'oxyde de silicium (2200 kg/m³), lorsque le canal fluidique 25 est destiné à être occupé par une solution aqueuse, de densité 1000 Kg/m³, compte tenu de l'épaisseur $W_{28}$ de 2 μm du canal plein 28, les expressions (2) ou (3) conduisent à une largeur $L_{28}$ du canal plein de l'ordre de 3.6 μm.

Lorsqu'une particule 5, entraînée par le fluide 4 à analyser, pénètre dans le canal fluidique 25 et circule dans ce dernier, la variation de masse $\delta m$ du canal fluidique 25 induit une variation $\delta f$ de la fréquence de résonance de l'oscillateur 20. Par particule, on entend une particule biologique, par exemple une cellule, un microorganisme, une spore, un virus. Il peut également s'agir d'une particule organique ou minérale, ou d'une particule gazeuse, par exemple une bulle d'air. Lorsque la particule a pour effet d'alourdir le canal fluidique 25, la fréquence de résonance diminue et $\delta f < 0$. Lorsque la particule a pour effet d'alléger le canal fluidique 25, la fréquence de résonance augmente et $\delta f > 0$.

Un élément important de l'invention est que la variation de la fréquence de résonance $\delta f$ est détectée par l'ensemble source de lumière 6, guide d'onde 26 et photodétecteur 8. Cet aspect est décrit plus en détail en lien avec les figures 4A à 4C.

La configuration illustrée sur la figure 2A représente un cas ou le canal fluidique 25 et le guide d'onde 26 sont symétriques l'un de l'autre par un plan médian P perpendiculaire au plan principal XY et s'étendant à égale distance de la première plaque et de la deuxième plaque. De ce fait, la répartition spatiale des masses de la première plaque 21 est identique à la répartition spatiale des masses de la deuxième plaque 22.

D'autres configurations sont envisageables, selon lesquelles le canal fluidique 25 et le guide d'onde 26 ne sont que partiellement symétriques. Par partiellement symétrique, on entend symétrique sur une portion du canal fluidique 25 et du guide d'onde 26. La figure 2E montre par exemple une variante de la configuration représentée sur la figure 2A, dans laquelle le guide d'onde 26 s'étend parallèlement aux quatre côtés de la deuxième plaque 22 de façon similaire à la configuration représentée sur les figures 2A, 2C et 2D. Le guide d'onde 26 comporte un guide d'onde de référence $26_{ref}$ et une cavité résonante $26_c$. La lumière se propage entre une entrée photonique $26_{in}$, optiquement couplée à une source de lumière 6 et une sortie photonique $26_{out}$, optiquement couplée à un photodétecteur 8. De même que dans la configuration précédente, l'onde lumineuse résultante 7' détectée par le photodétecteur est formée d'une onde lumineuse de référence $7_{ref}$, se propageant depuis l'entrée photonique $26_{in}$, et une partie de l'onde lumineuse $7_c$ se propageant dans la cavité résonante $26_c$. Le canal fluidique 25 comporte une seule branche, s'étendant parallèlement aux trois des quatre côtés de la première plaque 21. Pour équilibrer les masses respectives de la première plaque 21 et de la deuxième plaque 22, un canal de compensation 25', de section identique au canal plein 28, est formé dans la première plaque 21. Le canal de compensation 25' est formé d'oxyde de silicium. Ainsi, le canal de compensation permet une compensation entre la masse du circuit fluidique 25 rempli du fluide et la masse du canal plein 28.

La figure 2F montre une variante de la configuration représentée sur la figure 2E, selon laquelle le canal fluidique 25 s'étend parallèlement à trois côtés de la première plaque 21, tandis que le guide d'onde s'étend sur trois côtés de la deuxième plaque 22. Selon cette configuration, le résonateur comporte un guide d'onde 26, s'étendant sur la deuxième plaque 22, et formé par une structuration de la couche supérieure $22_s$, de façon à former un canal photonique d'épaisseur 220 nm et de largeur 500 nm. Le guide d'onde 26 s'étend entre l'entrée photonique $26_{in}$ et la sortie photonique $26_{out}$. Selon cette configuration, un circuit photonique de référence $26_{ref}$ s'étend à l'extérieur de la deuxième plaque et est également couplé au photodétecteur 8. Ainsi, le photodétecteur détecte une onde lumineuse résultante 7' formée par une onde lumineuse de référence $7_{ref}$, se propageant depuis la source de lumière 6 et une onde lumineuse 7 se propageant à travers le guide d'onde 26.

Quelle que soit la configuration retenue, il est préférable que le canal fluidique 25 et le guide d'onde 26 s'étendent au niveau d'au moins un maximum de déformation, ou ventre, de chaque plaque, voire selon chaque maximum de déformation de chaque plaque. Plus la déformation du canal fluidique 25 et du guide d'onde 26 est importante, plus la sensibilité de la mesure est élevée. Des simulations préalables, telles que celles représentées sur la figure 1B, permettent de prévoir la position de chaque maximum déformation. On peut se baser sur ces simulations pour définir le cheminement du canal fluidique 25 et du guide d'onde 26. La notion de maximum de déformation peut être élargie à une zone de l'oscillateur dans lequel l'amplitude de déformation est comprise entre une déformation maximale de l'oscillateur et 50% de ladite déformation maximale.

Les figures 3A à 3J schématisent les principales étapes technologiques de réalisation de l'oscillateur 20 décrit en lien avec les figures 2A à 2D. Chaque figure montre une coupe, perpendiculairement au plan principal XY, d'un substrat 2 permettant la formation de la première plaque 21 et de la deuxième plaque 22.

La figure 3A montre un substrat de type SOI comportant une couche principale $2_p$ de silicium monocristallin, d'épaisseur 5 $\mu$m, une couche enterrée $2_b$ d'épaisseur 1.5 $\mu$m, usuellement désignée par le terme "burried oxyde" et une couche support $2_k$, usuellement désignée par le terme "bulk".

Selon une étape représentée sur la figure 3B, on forme des cavités 31, s'étendant selon une profondeur de 2 $\mu$m, par photolithographie suivie d'une gravure sèche.

Selon une étape représentée sur la figure 3C, on effectue un dépôt d'une couche d'oxyde de silicium ($SiO_2$) 32 par dépôt chimique en phase vapeur assisté par plasma, usuellement désigné par l'acronyme PECVD signifiant Plasma Enhanced Chemical Vapor Déposition. Cela permet de combler les cavités 31 par l'oxyde de silicium, ce qui permet de former le canal plein 28.

La couche d'oxyde ainsi déposée subit une gravure par contre-masquage puis un polissage mécanochimique, de façon à obtenir une fine couche d'oxyde de silicium, d'épaisseur de l'ordre de 100 à 200 nm, formant une couche dite couche intermédiaire $2_m$, comme représenté sur la figure 3D.

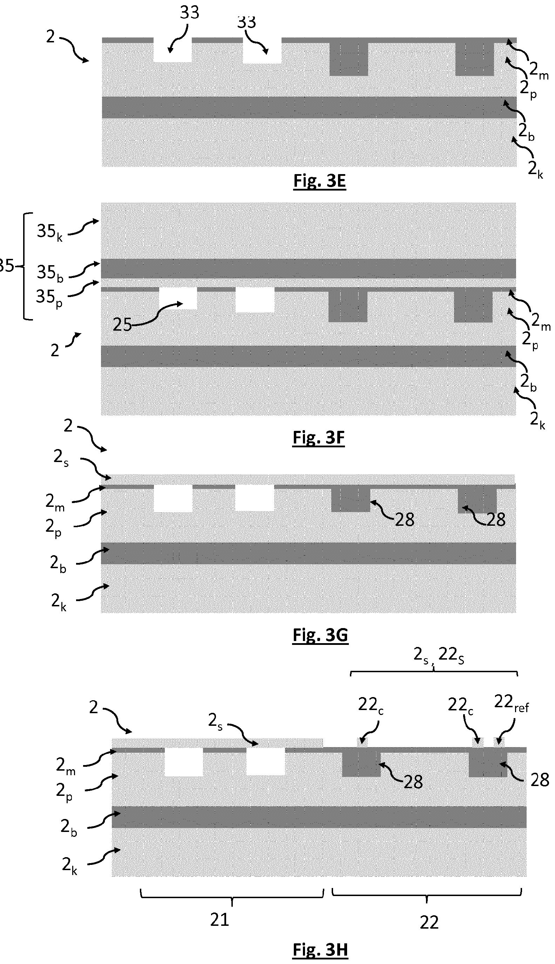

La figure 3E montre la formation de cavités fluidiques 33, de profondeur 4 $\mu$m, par photolithographie et gravure sèche. Les cavités fluidiques forment le canal fluidique 25.

Le substrat 20 est ensuite recouvert par un substrat auxiliaire 35, de type SOI, comportant une couche principale $35_p$ en silicium monocristallin, une couche d'oxyde enterrée $35_b$ et une couche inférieure $35_k$ de silicium. Cf. figure 3F. La couche principale $35_p$ du substrat auxiliaire 35 est déposée sur la couche intermédiaire $2_m$ et collée sur cette dernière par scellement moléculaire. La couche d'oxyde enterrée $35_b$ et la couche inférieure $35_k$ du substrat auxiliaire 35 sont ensuite retirées par gravure pour ne laisser subsister que la couche principale $35_p$, éventuellement amincie, sur la couche intermédiaire $2_m$, la couche principale $35_p$ formant une couche supérieure $2_s$ du substrat 2.Cette étape est représentée sur la figure 3G.

La figure 3H montre une étape de gravure de la couche supérieure 2s, permettant la formation du guide d'onde 26, et plus précisément de la couche supérieure $22_s$ de la plaque 22. On a représenté, sur la figure 3H, la partie du substrat 2 correspondant à la première plaque 21 et la partie du substrat 2 correspondant à la deuxième plaque 22. Les couches $2_s$, $2_m$, $2_p$, $2_b$ et $2_k$ du

substrat forment, sur la première plaque 21, les couches $21_s$, $21_m$, $21_p$, $21_b$ et $21_k$ et, sur la deuxième plaque 22, les couches $22_s$, $22_m$, $22_p$, $22_b$ et $22_k$ représentées sur les figures 2B et 2C. Le canal fluidique 25 est ménagé dans la couche principale $21_p$ et dans la couche intermédiaire $21_m$ de la première plaque. Le canal plein 28 est ménagé dans la couche principale $22_p$ de la deuxième plaque, le cœur du guide d'onde 26 étant formé dans la couche supérieure $22_s$ de la deuxième plaque. La couche intermédiaire $22_m$ a une épaisseur faible, typiquement inférieure à 200 nm, et n'a pas d'influence sur le guide d'onde.

Suite à l'étape représentée sur la figure 3H, l'entrefer 15 est gravé dans le substrat 2, de même que les éléments d'ancrage et l'élément de liaison 23. Cela permet de délimiter la partie fixe 10 de l'oscillateur 20.

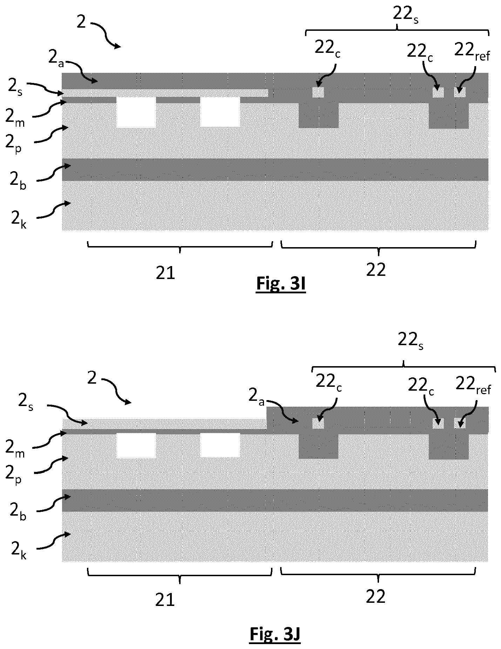

Selon une variante, suite à l'étape représentée sur la figure 3H, et préalablement à la gravure de l'entrefer, des ancrages et de l'élément de liaison, une couche d'encapsulation $2_a$ est déposée sur la couche supérieure $2_s$, comme représenté sur la figure 3I. La couche d'encapsulation $2_a$ peut être réalisée selon un troisième matériau, par exemple de l'oxyde de silicium, et déposée par PECVD. Son épaisseur est par exemple comprise entre 200nm et 600nm. La couche d'encapsulation 2a permet de protéger le circuit photonique 26 ménagé sur la plaque 22. Elle permet également de former une surface plane, sur laquelle d'autres composants peuvent être formés.

De façon optionnelle, la couche d'encapsulation peut être retirée dans la partie du substrat destinée à former la première plaque 21, comme représenté sur la figure 3J. Selon ce mode de réalisation, le guide d'onde comporte un troisième matériau qui correspond au matériau de la couche d'encapsulation. Dans cet exemple, le troisième matériau est identique au deuxième matériau formant le canal plein 28. De même que précédemment décrit, le troisième matériau a un indice de réfraction $n_3$ strictement inférieur à celui du premier matériau, formant la couche supérieure $2_s$. Au niveau de la deuxième plaque 22, la couche supérieure $2_s$ forme une couche $22_s$ correspondant au cœur du guide d'onde 26. La couche d'encapsulation $2_a$ et le canal plein 28 agissent dans le guide d'onde en tant qu'éléments de confinement.

La figure 4A schématise une évolution de la fréquence de résonance $f$ de l'oscillateur 20, formé par la première plaque 21 et la deuxième plaque 22, lors de la détection d'une particule 5 dans le canal fluidique 25. Le pic de résonance est décalé d'une variation de fréquence de résonance $\delta f$. Un élément important de l'invention est la détection de la variation de fréquence de résonance $\delta f$ par un circuit photonique intégré à l'oscillateur 20.

Selon une première configuration, schématisée sur les figures 2A et 2D ou sur la figure 2E, le guide d'onde 26 forme une cavité optique 26c, apte à confiner la lumière, ainsi qu'un guide d'onde de référence $26_{ref}$. La source de lumière 6 injecte une onde lumineuse 7 dans le guide d'onde 26. Une partie de l'onde lumineuse se propage jusqu'au détecteur selon le guide d'onde de référence $26_{ref}$ et forme une onde lumineuse de référence $7_{ref}$. Une partie de l'onde lumineuse est couplée à la cavité résonante $26_c$ et demeure confinée dans cette dernière en formant une onde lumineuse confinée $7_c$. Une partie de l'onde lumineuse $7_c$ guidée dans la cavité résonante $26_c$ subit un découplage, et s'additionne à l'onde lumineuse de référence pour former une onde lumineuse résultante 7', guidée vers le photodétecteur 8 par le tronçon de guide de lumière s'étendant selon l'élément d'ancrage $24_d$. Ainsi, le photodétecteur 8 détecte l'onde lumineuse de référence $7_{ref}$, ainsi qu'une partie de l'onde lumineuse confinée $7_c$. La quantité de lumière découplée de la cavité optique dépend de la géométrie du guide d'onde 26. Elle est par exemple faible lorsque l'oscillateur est au repos, les dimensions de la cavité étant alors optimisées pour que le découplage vers le photodétecteur soit faible. La déformation de la deuxième plaque 22, a pour effet de moduler le découplage optique de la cavité, modulant ainsi l'intensité de l'onde lumineuse détectée par le photodétecteur. La déformation de la deuxième plaque 22 est symétrique par rapport à la position de l'oscillateur au repos. Deux déformations, selon des sens opposés, ont lieu durant une période d'oscillation. Il en est de même du guide d'onde 26, du fait que ce dernier est intégré à la deuxième plaque 22. Ainsi, l'intensité de l'onde lumineuse détectée est modulée selon une fréquence de modulation $w$, telle que $w = 2f$. Lorsque la fréquence de résonance subit une variation $\delta f$, la fréquence de modulation w de l'amplitude lumineuse, détectée par le photodétecteur 8, subit une variation de $\delta w = 2\delta f$. La variation de fréquence $\delta f$ dépendant de la masse m de particules dans le canal, selon une fonction connue $m = g(\delta f)$, la masse m peut être obtenue à partir d'une mesure de la variation de fréquence de modulation $\delta w$ selon l'expression $$m = g\left(\frac{\delta w}{2}\right).$$ La figure 4B schématise une variation temporelle $Amax$ $(t)$ de l'amplitude maximale $Amax$ de la déformation de la plaque en fonction du temps t, cette amplitude étant modulée selon la fréquence de résonance $f$. La figure 4C illustre une variation temporelle S$(t)$ du signal $S$ lumineux détecté par le photodétecteur 8, le signal étant minimal à chaque extremum d'amplitude et maximal lorsque l'amplitude est nulle. Le signal est modulé selon la fréquence de modulation w.

Selon une autre configuration, représentée sur la figure 2F, la variation de la fréquence de résonance de la deuxième plaque 22 est mesurée par interférométrie optique, par exemple selon les principes d'un interféromètre de Mach Zender. Selon cette configuration, l'onde lumineuse émise par la source de lumière est divisée entre une onde lumineuse 7, se propageant à travers le guide d'onde 26 jusqu'au photodétecteur 8, et une onde lumineuse de référence $7_{ref}$, suivant un trajet optique de référence, et se propageant jusqu'au photodétecteur 8. L'onde lumineuse de référence est guidée par le circuit photonique de référence $26_{ref}$ décrit en lien avec la figure 2F. Le circuit optique de référence définit un chemin optique de référence. Il est par exemple constitué de miroirs ou d'une fibre optique. Le trajet de l'onde lumineuse de référence $7_{ref}$ est fixe et est, de préférence, similaire au chemin optique parcouru par l'onde lumineuse 7 lorsque la plaque 22 est au repos. Sous l'effet de l'oscillation de la plaque 22 à une fréquence de résonance $f$, le chemin optique de l'onde lumineuse 7 est modulé selon une fréquence $2f$, tandis que le chemin optique de l'onde lumineuse de référence $7_{ref}$ reste fixe. L'onde lumineuse de référence $7_{ref}$ et l'onde lumineuse 7 se propageant à travers le guide d'onde 26 sont additionnées en amont du photodétecteur 8. Les interférences entre l'onde lumineuse 7 et l'onde lumineuse de référence $7_{ref}$ sont détectées par le photodétecteur 8, ces interférences produisant une modulation du signal $S$ formé par le photodétecteur 8 selon une fréquence de modulation $w$, telle que $w = 2f$. Lorsque la fréquence de résonance subit une variation $\delta f$, la fréquence de modulation subit une variation de $\delta w = 2\delta f$. La variation de fréquence $\delta f$ dépendant de la masse $m$ de particules dans le canal, selon une fonction connue $m = g(\delta f)$, la masse m peut être obtenue à partir de la variation de fréquence de modulation $\delta w$ selon l'expression $m = g(\frac{\delta w}{2})$.

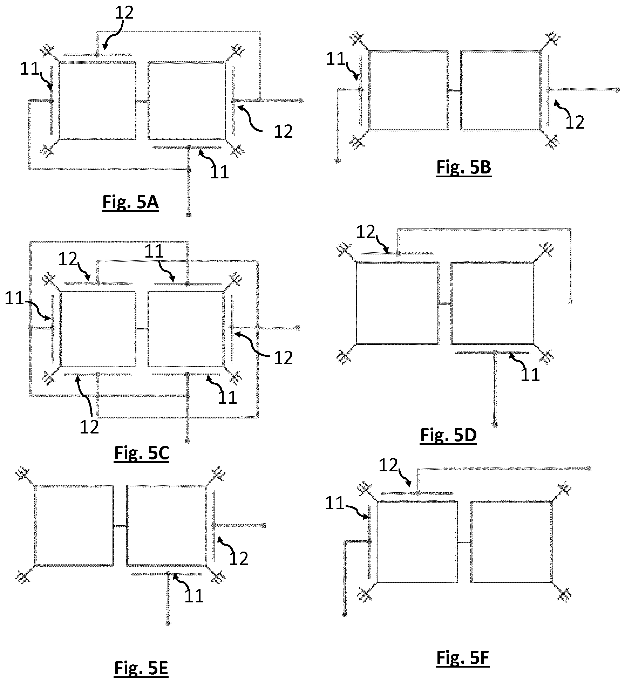

Les figures 5A à 5F montrent différentes configurations d'actionnement électrostatique de l'oscillateur 20. Dans chaque configuration, l'actionnement est réalisé au moyen d'au moins :

- une première électrode 11, solidaire de la partie fixe 10 du résonateur, et soumise à une tension comportant une première composante continue $V_{DC}$ à laquelle s'ajoute une première composante tension alternative $V_{AC}$ ;
- une deuxième électrode 12, solidaire de la partie fixe 10 du résonateur, et soumise à une tension comportant une deuxième composante continue, qui est dans cet exemple la première composante continue $V_{DC}$, à laquelle s'ajoute une deuxième composante tension alternative $V'_{AC}$ déphasée de 180° par rapport à la première composante alternative $V_{AC}$.

Les configurations illustrées sur les figures 5B, 5D, 5E et 5F correspondent à des configurations minimales, selon lesquelles l'oscillateur est actionné par deux électrodes déphasées l'une par rapport à l'autre, et de préférence en opposition de phase l'une par rapport à l'autre. La configuration représentée sur la figure 5C est considérée comme optimale, car on maximise le nombre d'électrodes. Cela permet d'augmenter l'intensité de la force électrostatique appliquée à l'oscillateur 20, la surface de l'oscillateur en vis-à-vis des électrodes étant augmentée.

La force électrostatique $F(t)$, s'appliquant sur l'oscillateur 20, à un instant $t$, sous l'effet de l'actionnement électrostatique exercé par une électrode polarisée selon une tension alternative $V(t)$, peut être exprimée par la relation suivante :

$$F(t) = \frac{\varepsilon_0 \varepsilon_r S}{2(g - \delta g)^2} V(t)^2, (6)$$

où :

- $\varepsilon_0$ et $\varepsilon_r$ représentent respectivement les permittivités diélectriques du vide et du milieu ambiant 3 dans lequel est placé le résonateur ;
- $S$ est la surface de l'oscillateur en vis-à-vis de l'électrode ;
- $g$ est l'épaisseur de l'entrefer 15, séparant l'électrode de l'oscillateur ;
- $\delta g$ est le déplacement induit par la force électrostatique, c'est-à-dire une variation de $g$ sous l'effet de ladite force. $\delta g$ peut être négligé devant $g$. Dans l'exemple considéré, $g = 500$ nm et $V_{AC} = 5$ V. Si l'on considère une plaque carré de côté 100 $\mu$m et d'épaisseur 5 $\mu$m, $\delta g$ est de l'ordre de quelques nm donc $\delta g \ll g$.

D'une manière générale, lorsque la variation de masse est très petite devant la masse effective $m_{eff}$ du résonateur, la résolution massique $\delta m$ du résonateur peut être estimée selon l'expression suivante :

$$\delta m = 2 \frac{m_{eff}}{\omega_0} \delta \omega \ (7).$$

où $\omega_0$ désigne la fréquence de résonance du résonateur.

Dans le cas d'une plaque carrée de côté 100 $\mu$m et d'épaisseur 5 $\mu$m, si on considère un entrefer d'épaisseur $g = 500$ nm, une tension $V_{DC} = 100$ V et $V_{AC} = 2$ V modulée selon une pulsation $w$, on obtient une résolution massique de l'ordre de quelques attogrammes.

Les figures 6A, 6B et 6C représentent différentes configurations d'éléments d'ancrage 24 maintenant un oscillateur 20 formé de deux plaques 21 et 22 reliées par un élément de liaison 23. La figure 7A schématise un résonateur comportant un premier oscillateur élémentaire 41 et un deuxième oscillateur élémentaire 42 en forme de disque, reliés par un élément de liaison 43 et quatre éléments d'ancrage 24. La figure 7B schématise un résonateur comportant un premier oscillateur élémentaire 51 et un deuxième oscillateur élémentaire 52 en forme d'anneau, reliés par un élément de liaison 53 et quatre éléments d'ancrage 24. La figure 7C est une photographie d'un résonateur tel que schématisé sur la figure 7B.

Dans les différents modes de réalisations précédemment décrits, l'oscillateur 20 comporte deux oscillateurs élémentaires reliés par un élément de liaison. L'oscillateur 20 peut comporter un nombre d'oscillateurs élémentaires supérieur à 2. Selon le mode de réalisation décrit en lien avec la figure 8, l'oscillateur 20 comporte un unique oscillateur 60 prenant la forme d'une plaque rectangulaire de longueur *l* et de largeur $L = \frac{l}{2}$, dont :

- une première partie est parcourue par un canal fluidique 65, similaire au canal fluidique 25 précédemment décrit,
- et une deuxième partie est parcourue par un guide d'onde 66, similaire au guide d'onde 26 précédemment décrit.

Sur la figure 8, on a représenté l'oscillateur immobile, en filaire, et l'oscillateur en mouvement, de façon analogue à la figure 1B.

Le canal fluidique et le guide d'onde s'étendent selon plusieurs ventres d'oscillation du résonateur 1. Comme décrit dans les exemples précédents, la déformation du canal fluidique, à une fréquence de résonance, entraîne une déformation du guide d'onde, à la même fréquence de résonance. La fréquence de résonance peut être détectée par détection d'une onde lumineuse parcourant le guide d'onde, au moyen d'un photodétecteur couplé au guide d'onde. L'onde lumineuse résultant du guide d'onde et atteignant le photodétecteur est modulée selon une fréquence de modulation deux fois supérieure à la fréquence de résonance.

Les oscillateurs selon l'invention peuvent être réalisés selon des procédés de fabrication connus dans le domaine de la microélectronique, par exemple en utilisant des substrats de fabrication, usuellement désignés par le terme wafer, de diamètre 200 mm selon une technologie SOI.

L'invention permet d'obtenir des oscillateurs de grande surface, comportant différents canaux, dans lesquels différents types de particules peuvent circuler, et en particulier des canaux dédiés à des particules de petite taille, et des canaux dédiés à des particules de grande taille.

**Revendications**

1. Résonateur électromécanique (1), comportant une partie fixe (10) et un oscillateur (20, 60), l'oscillateur étant apte à osciller selon une fréquence de résonance (*f*), l'oscillateur comportant:

 ▪ un canal fluidique (25), définissant un circuit fluidique, ménagé dans l'oscillateur (20,60), et destiné à accueillir un fluide (4), le canal fluidique étant apte à être déformé selon la fréquence de résonance, sous l'effet de l'oscillation de l'oscillateur ;
 le résonateur étant **caractérisé en ce qu'**il comprend également :

 ▪ un guide d'onde (26), définissant un circuit photonique, ménagé dans l'oscillateur (20,60), et destiné à guider une onde lumineuse (7, 7', $7_c$, $7_{ref}$) entre une entrée ($26_{in}$) et une sortie ($26_{out}$) du guide d'onde, le guide d'onde (26) étant apte à être déformé selon la fréquence de résonance (*f*), sous l'effet de l'oscillation de l'oscillateur ;
 ▪ l'entrée du guide d'onde ($26_{in}$) étant apte à être optiquement couplée à une source de lumière (6), la sortie du guide d'onde étant apte à être optiquement couplée à un photodétecteur (8), de façon que le photodétecteur soit apte à former un signal (*S*) représentatif de l'onde lumineuse propagée par le guide d'onde vers le photodétecteur, cette dernière étant modulée selon une fréquence de modulation (w) dépendant de la fréquence de résonance (*f*);

de telle sorte que lorsque sous l'effet d'une variation ($\delta m$) d'une masse (*m*) du fluide (4), induisant une variation ($\delta f$) de la fréquence de résonance, la variation de masse ($\delta m$) peut être détectée par une mesure de la fréquence de modulation (w) ou par une mesure de la variation de la fréquence de modulation ($\delta w$) du signal (*S*) formé par le photodétecteur.

2. Résonateur selon la revendication 1, dans lequel canal fluidique (25) et le guide d'onde (26) s'étendent, dans l'oscillateur (20,60), en étant, au moins partiellement, symétriques l'un par rapport à l'autre.

3. Résonateur selon l'une quelconque des revendications précédentes, dans lequel l'oscillateur oscillant selon une amplitude, l'oscillateur (20,60) comporte des ventres d'oscillation, au niveau desquels l'amplitude de l'oscillation est maximale, et des noeuds d'oscillation, au niveau desquels l'amplitude de l'oscillation est minimale, le canal fluidique (25) et le guide d'onde (26) s'étendant à travers au moins un ventre d'oscillation.

4. Résonateur selon l'une quelconque des revendications précédentes, dans lequel le guide d'onde (26) comporte :

 - une couche mince ($22_c$, $22_{ref}$) d'un premier matériau, d'un premier indice de réfraction ($n_1$) ;
 - un canal plein (28), formé d'un deuxième matériau, d'un deuxième indice de réfraction ($n_2$), le deuxième indice de réfraction étant strictement inférieur au premier indice de réfraction, le canal plein étant ménagé, dans l'oscillateur (20,60), sous la couche mince, de telle sorte que l'onde lumineuse (7, 7', $7_c$, $7_{ref}$) est apte à se propager, dans la couche mince, en regard du canal plein (28) ;

- un troisième matériau, d'un troisième indice de réfraction $(n_3)$, le troisième indice de réfraction étant strictement inférieur au premier indice de réfraction $(n_1)$, la couche $(22_c, 22_{ref})$ de premier matériau s'étendant entre le canal plein (28) et le troisième matériau.

5. Résonateur selon la revendication 4, dans lequel :

- le troisième matériau est formé par un milieu ambiant (3) dans lequel est plongé le résonateur ;
- ou le troisième matériau est formé par une couche d'encapsulation (2a) déposée sur la couche de premier matériau $(22_c, 22_{ref})$.

6. Résonateur selon la revendication 5 ou la revendication 4, dans lequel le canal fluidique (25) définit un volume fluidique, et dans lequel canal plein (28) définit un volume de confinement, le résonateur étant tel que le volume fluidique, multiplié par la densité du fluide (4) apte à circuler dans le canal fluidique, est égal, à 30% près, au volume de confinement multiplié par la densité du deuxième matériau.

7. Résonateur selon l'une quelconque des revendications précédentes, comportant au moins un élément d'ancrage (24a, 24b, 24c, 24d), reliant l'oscillateur (20,60) à la partie fixe (10), le circuit fluidique (25) et/ou le guide d'onde (26)s'étendant le long de l'élément d'ancrage.

8. Résonateur selon l'une quelconque des revendications précédentes, dans lequel l'oscillateur (20,60) s'étend, dans un plan principal (XY), selon une largeur ou une longueur ou un diamètre, l'épaisseur de l'oscillateur, perpendiculairement au plan principal, étant au moins dix fois inférieure à ladite largeur, longueur ou diamètre.

9. Résonateur selon l'une quelconque des revendications 1 à 7, dans lequel l'oscillateur (20) comporte une pluralité d'oscillateurs élémentaires (21, 22), de telle sorte que le circuit fluidique (25) est ménagé dans un premier oscillateur élémentaire (21) et que le guide d'onde (26) est ménagé dans un deuxième oscillateur élémentaire (22), différent du premier résonateur élémentaire (21), le premier oscillateur élémentaire et le deuxième oscillateur élémentaire étant reliés l'un à l'autre par un élément de liaison (23).

10. Résonateur selon la revendication 9, dans lequel le premier oscillateur élémentaire (21) et le deuxième oscillateur élémentaire (22) s'étendent chacun, dans un plan principal (XY), selon une largeur ou une longueur ou un diamètre, l'épaisseur de chaque oscillateur élémentaire, perpendiculairement au plan principal, étant au moins dix fois inférieure à ladite largeur, longueur ou diamètre.

11. Résonateur selon l'une quelconque des revendications précédentes, comportant un transducteur d'actionnement (11), apte à induire une oscillation de l'oscillateur (20, 60), le transducteur d'actionnement étant :

- une électrode (11), apte à agir sur l'oscillateur par transduction électrostatique ;
- et/ou un élément piézoélectrique, relié à l'oscillateur.

12. Résonateur selon l'une quelconque des revendications précédentes, dans lequel le guide d'onde (26) comporte un guide d'onde de référence $(26_{ref})$ optiquement couplé à une cavité optique résonante $(26_c)$, agencés de telle sorte que le photodétecteur est configuré pour détecter une onde lumineuse (7') comportant une onde lumineuse de référence $(7_{ref})$, se propageant à travers le guide d'onde de référence, et une partie d'une onde lumineuse dite confinée $(7_c)$, s'étant propagée dans la cavité optique résonante.

13. Résonateur selon l'une quelconque des revendications 1 à 11, dans lequel le guide d'onde (26) définit un chemin optique guidé sur l'oscillateur, le résonateur comportant un guide d'onde de référence $(26_{ref})$, s'étendant à l'extérieur de l'oscillateur, et définissant un chemin optique de référence, le guide d'onde de référence étant apte à être couplé à la source de lumière et au photodétecteur.

14. Procédé d'analyse d'un fluide, comportant des particules, à l'aide d'un résonateur selon l'une quelconque des revendications 1 à 13, comportant les étapes suivantes :

a) introduction du fluide dans le canal fluidique (25) ;
b) actionnement de l'oscillateur (20,60), de façon à induire des oscillations de l'oscillateur selon une fréquence de résonance $(f)$ ;
c) illumination du guide d'onde (26) par une source de lumière (6), émettant une onde lumineuse (7), de telle sorte que le guide d'onde est apte à propager l'onde lumineuse émise par la source de lumière à travers l'oscillateur ;
d) détection, par un photodétecteur (8), d'une onde lumineuse (7,7') transmise par le guide d'onde, et modulée par l'oscillation de l'oscillateur, et formation d'un signal $(S)$ représentatif de l'onde lumineuse détectée, le signal ainsi formé étant modulé selon une fréquence de modulation, la fréquence de modulation $(w)$ dépendant de la fréquence de résonance de l'oscillateur (*f*) ;
e) estimation d'une masse (*m*) du fluide en fonction de la fréquence de modulation (*w*), ou d'une variation de la fréquence de modulation (*δw*), du signal formé lors de l'étape d).

15. Procédé selon la revendication 14, dans lequel l'étape d) comporte une formation d'un signal d'interférence entre l'onde lumineuse (7) transmise par le guide d'onde (26) et une onde lumineuse de référence ($7_{ref}$) émise par la source de lumière et transmise par un guide d'onde de référence ($26_{ref}$).

16. Procédé selon la revendication 15, dans lequel le guide d'onde de référence s'étend à l'extérieur de l'oscillateur.

17. Procédé selon la revendication 14 ou la revendication 15, dans lequel le guide d'onde est apte à confiner l'onde lumineuse (7) émise par la source de lumière, une partie de l'onde lumineuse (7'), découplée du guide d'onde, se propageant vers le photodétecteur, l'intensité de l'onde lumineuse découplée du guide d'onde étant modulée selon une fréquence de modulation (*w*) dépendant de la fonction de la fréquence de résonance (*f*) de l'oscillateur.

## Patentansprüche

1. Elektromechanischer Resonator (1), der einen feststehenden Teil (10) und einen Oszillator (20, 60) aufweist, wobei der Oszillator geeignet ist, gemäß einer Resonanzfrequenz (f) zu schwingen, wobei der Oszillator aufweist:

   • einen Fluidkanal (25), der einen Fluidkreislauf definiert, im Oszillator (20, 60) ausgebildet ist und dazu bestimmt ist, ein Fluid (4) aufzunehmen, wobei der Fluidkanal geeignet ist, unter der Einwirkung der Schwingung des Oszillators gemäß der Resonanzfrequenz verformt zu werden;

   wobei der Resonator **dadurch gekennzeichnet ist, dass** er zudem umfasst:

   • einen Wellenleiter (26), der eine photonische Schaltung definiert, im Oszillator (20, 60) ausgebildet ist und dazu bestimmt ist, eine Lichtwelle (7, 7', $7_c$, $7_{ref}$) zwischen einem Eingang ($26_{in}$) und einem Ausgang ($26_{out}$) des Wellenleiters zu leiten, wobei der Wellenleiter (26) geeignet ist, unter der Einwirkung der Schwingung des Oszillators gemäß der Resonanzfrequenz (f) verformt zu werden;
   • wobei der Eingang des Wellenleiters ($26_{in}$) geeignet ist, optisch mit einer Lichtquelle (6) gekoppelt zu werden, wobei der Ausgang des Wellenleiters geeignet ist, optisch mit einem Fotodetektor (8) gekoppelt zu werden, so dass der Fotodetektor geeignet ist ein Signal (S) zu bilden, das für die vom Lichtleiter zum Fotodetektor ausgebreitete Lichtwelle repräsentativ ist, wobei Letztere gemäß einer von der Resonanzfrequenz (f) abhängigen Modulationsfrequenz (w) moduliert ist;

   so dass unter der Einwirkung einer Änderung (δm) einer Masse (m) des Fluids (4), die zu einer Änderung (δf) der Resonanzfrequenz führt, die Massenänderung (δm) durch eine Messung der Modulationsfrequenz (w) oder durch eine Messung der Änderung der Modulationsfrequenz (δm) des vom Fotodetektor gebildeten Signals (S) detektiert werden kann.

2. Resonator nach Anspruch 1, bei dem sich der Fluidkanal (25) und der Wellenleiter (26) im Oszillator (20, 60) erstrecken, wobei sie zumindest teilweise symmetrisch zueinander sind.

3. Resonator nach einem der vorhergehenden Ansprüche, bei dem der Oszillator gemäß einer Amplitude schwingt, der Oszillator (20, 60) Schwingungsbäuche aufweist, an denen die Amplitude der Schwingung maximal ist, und Schwingungsknoten, an denen die Amplitude der Schwingung am kleinsten ist, wobei sich der Fluidkanal (25) und der Wellenleiter (26) durch mindestens einen Schwingungsbauch hindurch erstrecken.

4. Resonator nach einem der vorhergehenden Ansprüche, bei dem der Wellenleiter (26) aufweist:

   - eine dünne Schicht ($22_c$, $22_{ref}$) aus einem ersten Material mit einem ersten Brechungsindex ($n_1$);
   - einen gefüllten Kanal (28), der aus einem zweiten Material mit einem zweiten Brechungsindex ($n_2$) gebildet ist, wobei der zweite Brechungsindex strikt kleiner als der erste Brechungsindex ist, wobei der gefüllte Kanal im Oszillator (20, 60) unter der dünnen Schicht ausgebildet ist, so dass die Lichtwelle (7, 7', $7_c$, $7_{ref}$) geeignet ist, sich gegenüber dem gefüllten Kanal (28) in der dünnen Schicht auszubreiten;
   - ein drittes Material mit einem dritten Brechungsindex ($n_3$), wobei der dritte Brechungsindex strikt kleiner als der erste Brechungsindex ($n_1$) ist, wobei sich die Schicht ($22_c$, $22_{ref}$) aus dem ersten Material zwischen dem gefüllten Kanal (28) und dem dritten Material erstreckt.

5. Resonator nach Anspruch 4, bei dem:

- das dritte Material durch ein umgebendes Milieu (3) gebildet ist, in das der Resonator getaucht ist;
- oder das dritte Material durch eine Kapselungsschicht (2a) gebildet ist, die auf die Schicht aus dem ersten Material ($22_c$, $22_{ref}$) aufgebracht ist.

6. Resonator nach Anspruch 5 oder Anspruch 4, bei dem der Fluidkanal (25) ein Fluidvolumen definiert und bei dem der gefüllte Kanal (28) ein Umschließungsvolumen definiert, wobei der Resonator dergestalt ist, dass das Fluidvolumen multipliziert mit der Dichte des Fluids (4), das geeignet ist, im Fluidkanal zu zirkulieren, bis auf 30 % genau gleich dem Umschließungsvolumen multipliziert mit der Dichte des zweiten Materials ist.

7. Resonator nach einem der vorhergehenden Ansprüche, der mindestens ein Verankerungselement (24a, 24b, 24c, 24d) aufweist, das den Oszillator (20, 60) mit dem feststehenden Teil (10) verbindet, wobei sich der Fluidkreislauf (25) und/oder der Wellenleiter (26) entlang des Verankerungselements erstreckt bzw. erstrecken.

8. Resonator nach einem der vorhergehenden Ansprüche, bei dem sich der Oszillator (20, 60) in einer Hauptebene (XY) gemäß einer Breite oder einer Länge oder einem Durchmesser erstreckt, wobei die Dicke des Oszillators senkrecht zur Hauptebene mindestens zehn Mal geringer als die Breite, die Länge oder der Durchmesser ist.

9. Resonator nach einem der Ansprüche 1 bis 7, bei dem der Oszillator (20) eine Mehrzahl von elementaren Oszillatoren (21, 22) aufweist, so dass der Fluidkreislauf (25) in einem ersten elementaren Oszillator (21) ausgebildet ist und der Wellenleiter (26) in einem zweiten elementaren Oszillator (22) ausgebildet ist, der vom ersten elementaren Oszillator (21) verschieden ist, wobei der erste elementare Oszillator und der zweite elementare Oszillator durch ein Verbindungselement (23) miteinander verbunden sind.

10. Resonator nach Anspruch 9, bei dem sich der erste elementare Oszillator (21) und der zweite elementare Oszillator (22) jeweils in einer Hauptebene (XY) gemäß einer Breite oder einer Länge oder einem Durchmesser erstrecken, wobei die Dicke jedes elementaren Oszillators senkrecht zur Hauptebene mindestens zehn Mal geringer als die Breite, die Länge oder der Durchmesser ist.

11. Resonator nach einem der vorhergehenden Ansprüche, der einen Betätigungswandler (11) aufweist, der geeignet ist, eine Schwingung des Oszillators (20, 60) herbeizuführen, wobei der Betätigungswandler ist:

- eine Elektrode (11), die geeignet ist, durch elektrostatische Wandlung auf den Oszillator einzuwirken;
- und/oder ein piezoelektrisches Element, das mit dem Oszillator verbunden ist.

12. Resonator nach einem der vorhergehenden Ansprüche, bei dem der Wellenleiter (26) einen Referenzwellenleiter ($26_{ref}$) aufweist, der optisch mit einem optischen Hohlraumresonator ($26_c$) gekoppelt ist, die so eingerichtet sind, dass der Fotodetektor dazu ausgelegt ist, eine Lichtwelle (7') zu detektieren, die eine Referenzlichtwelle ($7_{ref}$) aufweist, die sich durch den Referenzwellenleiter hindurch ausbreitet, und einen ein Teil einer Lichtwelle, umschlossene Lichtwelle ($7_c$) genannt, die sich in dem optischen Hohlraumresonator ausgebreitet hat.

13. Resonator nach einem der Ansprüche 1 bis 11, bei dem der Wellenleiter (26) einen geführten optischen Pfad auf dem Oszillator definiert, wobei der Resonator einen Referenzwellenleiter ($26_{ref}$) aufweist, der sich außerhalb des Oszillators erstreckt und einen optischen Referenzpfad definiert, wobei der Referenzwellenleiter geeignet ist, mit der Lichtquelle und mit dem Fotodetektor gekoppelt zu werden.

14. Verfahren zur Analyse eines Fluids, das Partikel aufweist, mithilfe eines Resonators nach einem der Ansprüche 1 bis 13, umfassend die folgenden Schritte:

a) Einführen des Fluids in den Fluidkanal (25);
b) Betätigen des Oszillators (20, 60), so dass Schwingungen des Oszillators gemäß einer Resonanzfrequenz (f) herbeigeführt werden;
c) Beleuchten des Wellenleiters (26) mit einer Lichtquelle (6), die eine Lichtwelle (7) emittiert, so dass der Wellenleiter geeignet ist, die von der Lichtquelle emittierte Lichtwelle durch den Oszillator hindurch auszubreiten;
d) Detektion, durch einen Fotodetektor (8), einer Lichtwelle (7, 7'), die vom Wellenleiter übertragen wird und durch die Schwingung des Oszillators moduliert wird, und Bilden eines Signals (S), das für die detektierte Lichtwelle repräsentativ ist, wobei das so gebildete Signal gemäß einer Modulationsfrequenz moduliert ist, wobei die Modulationsfrequenz (w) von der Resonanzfrequenz des Oszillators (f) abhängt;
e) Schätzen einer Masse (m) des Fluids in Abhängigkeit von der Modulationsfrequenz (w) oder von einer Änderung der Modulationsfrequenz ($\delta$w) des im Schritt d) gebildeten Signals.

15. Verfahren nach Anspruch 14, bei dem der Schritt d) ein Bilden eines Interferenzsignals zwischen der vom Wellenleiter (26) übertragenen Lichtwelle (7) und einer Referenzlichtwelle ($7_{ref}$), die von der Lichtquelle emittiert wird und von einem Referenzwellenleiter ($26_{ref}$) übertragen wird, umfasst.

**16.** Verfahren nach Anspruch 15, bei dem sich der Referenzwellenleiter außerhalb des Oszillators erstreckt.

**17.** Verfahren nach Anspruch 14 oder Anspruch 15, bei dem der Wellenleiter geeignet ist, die von der Lichtquelle emittierte Lichtwelle (7) zu umschließen, wobei sich ein Teil der Lichtwelle (7'), der vom Wellenleiter entkoppelt ist, zum Fotodetektor hin ausbreitet, wobei die Intensität der entkoppelten Lichtwelle gemäß einer Modulationsfrequenz (w) moduliert ist, die von der Resonanzfrequenz (f) des Oszillators abhängt.

**Claims**

**1.** Electromechanical resonator (1), comprising a fixed portion (10) and an oscillator (20, 60), the oscillator being able to oscillate at a resonant frequency (*f*), the oscillator comprising:

   ▪ a fluidic channel (25), defining a fluidic circuit, produced in the oscillator (20, 60), and intended to receive a fluid (4), the fluidic channel being able to be deformed at the resonant frequency, under the effect of the oscillation of the oscillator;

the resonator being **characterized in that** it also includes:

   ▪ a waveguide (26), defining a photonic circuit, produced in the oscillator, and intended to guide a light wave (7, 7', $7_c$, $7_{ref}$) between an entrance ($26_{in}$) and an exit ($26_{out}$) of the waveguide, the waveguide (26) being configured to be deformed at the resonant frequency (*f*), under the effect of the oscillation of the oscillator;

   ▪ the entrance of the waveguide ($26_{in}$) being configured to be optically coupled to a light source (6), the exit of the waveguide being configured to be optically coupled to a photodetector (8), so that the photodetector is able to form a signal (*S*) representative of the light wave propagated by the waveguide towards the photodetector, said light wave being modulated at a modulation frequency (w) dependent on the resonant frequency (*f*);

such that when under the effect of a variation (δ*m*) in a mass (m) of the fluid (4), inducing a variation in the resonant frequency (δ*f*), the variation in mass (δ*m*) may be detected by measuring the modulation frequency (w) or by measuring the variation in the modulation frequency (δ*w*) of the signal (*S*) formed by the photodetector.

**2.** Resonator according to Claim 1, wherein the fluidic channel (25) and the waveguide (26) extend, in the oscillator (20, 60), while being, at least partially, symmetric with respect to each other.

**3.** Resonator according to any one of the preceding claims, wherein the oscillator oscillating at an amplitude, the oscillator (20, 60) comprises oscillation antinodes, level with which the amplitude of the oscillation is maximal and oscillation nodes, level with which the amplitude of the oscillation is minimal, the fluidic channel (25) and the waveguide (26) extending through at least one oscillation antinode.

**4.** Resonator according to any one of the preceding claims, wherein the waveguide (26) comprises:

   - a layer ($22_c$, $22_{ref}$) of a first material, of a first refractive index ($n_1$);
   - a solid channel (28), formed from a second material, of a second refractive index ($n_2$), the second refractive index being strictly lower than the first refractive index, the solid channel being produced, in the oscillator (20, 60), under the thin layer, such that the light wave (7, 7', $7_c$, $7_{ref}$) is able to propagate, in the thin layer, facing the solid channel (28);
   - a third material, of a third refractive index ($n_3$), the third refractive index being strictly lower than the first refractive index ($n_1$), the layer ($22_c$, $22_{ref}$) of first material lying between the solid channel (28) and the third material.

**5.** Resonator according to Claim 4, wherein:

   - the third material is formed by an ambient medium (3) in which the resonator is located;
   - or the third material is formed by an encapsulating layer (2a) deposited on the layer of first material ($22_c$, $22_{ref}$).

**6.** Resonator according to Claim 4 or to Claim 4, wherein the fluidic channel (25) defines a fluidic volume, and wherein the solid channel (28) defines a confining volume, the resonator being such that the fluidic volume, multiplied by the density of the fluid (4) able to flow through the fluidic channel, is equal, to within 30%, to the confining volume multiplied by the density of the second material.

**7.** Resonator according to any one of the preceding claims, comprising at least one anchoring element (24a, 24b, 24c, 24d), joining the oscillator (20, 60) to the fixed portion (10), the fluidic circuit (25) and/or the waveguide (26) extending along the anchoring element.

8. Resonator according to any one of the preceding claims, wherein the oscillator (20, 60) extends, in a main plane (XY), along a width or a length or a diameter, the thickness of the oscillator, perpendicular to the main plane, being at least ten times smaller than the width, length or diameter.

9. Resonator according to any one of claims 1 to 7, wherein the oscillator (20, 60) comprises a plurality of elementary oscillators (21, 22), such that the fluidic circuit (25) is produced in a first elementary oscillator (21) and the waveguide (26) is produced in a second elementary oscillator (22), different from the first elementary oscillator (21), the first elementary oscillator and the second elementary oscillator being joined to each other by a linking element (23).

10. Resonator according to Claim 9, wherein the first elementary oscillator (21) and the second elementary oscillator (22) each extend, in a main plane (XY), along a width or a length or a diameter, the thickness of each elementary oscillator, perpendicular to the main plane, being at least ten times smaller than said width, length or diameter.

11. Resonator according to any one of the preceding claims, comprising an actuating transducer (11), configured to induce an oscillation of the oscillator (20, 60), the actuating transducer being:

- an electrode (11), able to act on the oscillator by electrostatic transduction;
- or a piezoelectric element, joined to the oscillator.

12. Resonator according to any one of the preceding claims, wherein the waveguide (26) comprises a reference waveguide ($26_{ref}$) that is optically coupled to a resonant optical cavity ($26_c$), such that the photodetector is configured to detect a light wave (7') comprising a reference light wave ($7_{ref}$), which propagates through the reference waveguide, and a portion of what is called a confined light wave ($7_c$), which propagates through the resonant optical cavity.

13. Resonator according any one of claims 1 to 11, wherein the waveguide (26) defines a guided optical path in the oscillator, and wherein the resonator comprises a reference waveguide ($26_{ref}$), extending out of the oscillator, and defining a reference optical path, the reference waveguide being able to be coupled to the light source and to the photodetector.

14. Method for analysing a fluid, containing particles, using a resonator according to any one of claims 1 to 13, comprising:

a) introducing the fluid into the fluidic channel (25);
b) actuating the oscillator (20, 60), so as to induce oscillations of the oscillator at a resonant frequency ($f$);
c) illuminating the waveguide (26) with a light source (6), which emits a light wave (7), such that the waveguide is able to propagate the light wave emitted by the light source through the oscillator;
d) detecting, with a photodetector (8), a light wave (7, 7') transmitted by the light guide, and modulated by the oscillation of the oscillator, and forming a signal ($S$) representative of the detected light wave, the signal thus formed being modulated at a modulation frequency ($w$), the modulation frequency depending on the resonant frequency ($f$) of the oscillator;
e) estimating a mass ($m$) of the fluid depending on the modulation frequency ($w$), or on a variation in the modulation frequency ($\delta w$), of the signal formed in step d).

15. Method according to Claim 14, wherein d) comprises forming a signal of interference between the light wave (7) transmitted by the waveguide (26) and a reference light wave ($7_{ref}$) emitted by the light source and transmitted by a reference waveguide ($26_{ref}$).

16. Method according to Claim 15, wherein the reference waveguide extends out of the oscillator.

17. Method according to Claim 14 or Claim 15, wherein the waveguide is able to confine the light wave (7) emitted by the light source, a portion of the light wave (7'), decoupled from the waveguide, propagating towards the photodetector, the intensity of the light wave decoupled from the waveguide being modulated at a modulation frequency ($w$) dependent on the function of the resonant frequency ($f$) of the oscillator.

**Fig.1A**

**Fig. 1B**

**Fig. 2A**

**Fig. 2B**

**Fig. 2C**

**Fig. 2D**

**Fig. 2E**

**Fig. 2F**

**Fig. 3A**

**Fig. 3B**

**Fig. 3C**

**Fig. 3D**

**Fig. 3E**

**Fig. 3F**

**Fig. 3G**

**Fig. 3H**

**Fig. 3I**

**Fig. 3J**

**Fig. 4A**

**Fig. 4B**

**Fig. 4C**

**Fig. 5A**

**Fig. 5B**

**Fig. 5C**

**Fig. 5D**

**Fig. 5E**

**Fig. 5F**

Fig. 6A

Fig. 6B

Fig. 6C

Fig. 7A

Fig. 7B

**Fig. 7C**

**Fig. 8**

**EP 3 462 145 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 8844340 B
- US 9182268 B
- WO 2016069634 A
- US 2010238454 A